# EUROPEAN PATENT APPLICATION

(11) **EP 4 503 851 A1**
(43) Date of publication of application: **05.02.2025**
(21) Application number: 24192667.4
(22) Date of filing: 02.08.2024
(51) Int. Cl.: H05B 3/26, H05B 3/28, H05B 3/34, H05B 3/36, H05B 3/06

(54) **HEATING ASSEMBLY**

(30) Priority: 04.08.2023 TW 112129325
(71) Applicant: Purple Cloud Development Pte. Ltd., Singapore 128424 (SG)
(72) Inventor: TSENG, HSIANG-CHIEH, Singapore (SG); KUO, SY-CHI, Singapore (SG)
(74) Representative: Grünecker Patent- und Rechtsanwälte PartG mbB

(57) **Abstract**

A heating assembly (10) includes a heating sheet (12) including a first insulating layer (121) and a heating wire (123) disposed on the heat sheet (12), and a wiring sheet (13) including an insulating base layer (131) disposed on the first insulating layer (121) and a wiring cable (133) disposed on the insulating base layer (131), the wiring cable (133) is electrically connected to the heating wire (123), wherein the wiring cable (133) has an impedance value that is lower than an impedance value of the heating wire (123).

## Description

### TECHNICAL FIELD

The present disclosure is related to the field of heating assembly, in particular a heating assembly for heat source simulation.

### BACKGROUND OF THE INVENTION

The background description provided herein is for the purpose of generally presenting the context of the disclosure. Work of the presently named inventors, to the extent the work is described in this background section, as well as aspects of the description that may not otherwise qualify as prior art at the time of filing, are neither expressly nor impliedly admitted as prior art against the present disclosure.

In the process of research and development of a computer system, thermal tests are conducted on various functional parameters of the computer system through a heater used to simulate the heat source to verify the reliability of the system. Thermal test analysis in the heat source area can be performed to assist the verification of the reliability of the system.

### SUMMARY OF THE INVENTION

Aspects of the disclosure provide a heating assembly. The heating assembly can include a heating sheet including a first insulating layer and a heating wire disposed on the heat sheet, and a wiring sheet including an insulating base layer disposed on the first insulating layer and a wiring cable disposed on the insulating base layer. Further, the wiring cable can be electrically connected to the heating wire, wherein the wiring cable has an impedance value that is lower than an impedance value of the heating wire.

In an embodiment, the ratio of the impedance value of the heating wire and the impedance value of the wiring cable is at least 3, preferably at least 30, and more preferably at least 70. In order to properly determine this ratio a wiring cable and a heating wire of same cross section are compared.

In some embodiments, the conductive material of the wiring cable is copper (resistivity of approx. 1.75E-05 Ωmm (1.75*10⁻⁵ Ωmm)) or copper alloy having a resistivity of less than 5.00E-05 Ωmm and the conductive material of the heating wire is selected from the group comprising brass having a resistivity of more than 6.00E-05 Ωmm (e.g. approx. 7.00E-05 Ωmm), stainless steel having a resistivity of more than 6.00E-04 Ωmm (e.g. 1.4301(SUS304) having approx. 7.00E-04 Ωmm) and an FeCrAl alloy having a resistivity of more than 1.00E-03 Ωmm (e.g. approx 1.40E-03 Ωmm). The resistivity is measured at 20°C.

In an embodiment, the heating sheet can further include a second insulating layer, the heating wire is disposed between the first insulating layer and the second insulating layer.

In an embodiment, the heating assembly can further include at least one conductive member, and the first insulating layer can include at least one first through hole. Further, the heating wire and the wiring cable are electrically connected to each other via the at least one conductive member through the at least one first through hole.

In some embodiments, the at least one conductive member can be one of a conductive screw, a conductive rivet, a solder, a conductive spring, a conductive spring clip, a conductive foam or a matching conductive socket and plug.

In some embodiments, the wiring sheet can be a flexible printed circuit board. In some embodiments, the insulating base layer can be a circuit board.

In an embodiment, the wiring sheet can further include an insulating cover layer, the wiring cable is disposed between the insulating base layer and the insulating cover layer, and the insulating base layer is disposed on the first insulating layer through the insulating cover layer.

In an embodiment, the heating assembly can further include at least one conductive member, the first insulating layer can include at least one first through hole, and the insulating cover layer can include at least one second through hole. Further, the heating wire and the wiring cable can be electrically connected to each other via the at least one conductive member through the at least one first through hole and the at least one second through hole.

In an embodiment, the heating wire can include a first heating sub-wire, a second heating sub-wire, and a third heating sub-wire that are separated from each other, at least two of the first heating sub-wire, the second heating sub-wire, and the third heating sub-wire have a different width. Further, the wiring cable can include a first wiring sub-wire, a second wiring sub-wire, and a third wiring sub-wire that are separated from each other and electrically connected to the first heating sub-wire, the second heating sub-wire, and the third heating sub-wire respectively.

In an embodiment, the first heating sub-wire, the second heating sub-wire, and the third heating sub-wire are wave-shaped, and at least two of the first heating sub-wire, the second heating sub-wire, and the third heating sub-wire have a different number of peaks.

In an embodiment, the heating assembly can further include a connecting cable that is connected to the wiring cable. In an embodiment, the heating assembly can further include a thermal block that is thermally coupled to the heating sheet and a connection point between the connecting cable and the wiring cable is located outside of a perimeter of the thermal block.

The above embodiments can be combined with the heating assembly as specified in claim 1 either individually or in any combination, at least as defined by the dependencies of the presented claims.

### BRIEF DESCRIPTION OF DRAWINGS

Unless specified otherwise, the accompanying drawings illustrate aspects of the innovative subject matter described herein. Referring to the drawings, wherein like reference numerals indicate similar parts throughout the several views, several examples of vapor chambers incorporating aspects of the presently disclosed principles are illustrated by way of example, and not by way of limitation.
Fig. 1 illustrates a three-dimensional view of a heating assembly according to a first embodiment of the present disclosure.
Fig. 2 illustrates an explosive view of the heating assembly as shown in Fig. 1.
Fig. 3 illustrates a plane view of the heating sheet 12, wiring sheet 13, and the connecting cable 15 as shown in Fig. 2.
Fig. 4 illustrates a sectional view of the heating assembly 10 as shown in Fig. 1.
Fig. 5 illustrates an enlarged sectional view of the heating assembly 10 as shown in Fig. 4.
Fig. 6 illustrates a three-dimensional view of the heating assembly according to a second embodiment of the present disclosure.
Fig. 7 illustrates an explosive view of the heating assembly as shown in Fig. 6.
Fig. 8 illustrates a plane view of the heating sheet 12B, wiring sheet 13B, and the connecting cable 15B of a heating assembly 10B according to a third embodiment of the present disclosure.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

With the rapid development of technology, the computing power of various electronic components has increased dramatically, and at the same time, a large amount of heat is generated. When the heat generated by the operation of the electronic components is too high, it is easy to cause damage to the electronic components, which in turn affects the reliability of the electronic components.

During the process of research and development of a computer system, thermal tests need to be conducted on various functional parameters of the computer system through a heater used to simulate a heat source to verify the reliability of the system. However, the impedance of conductive wires located outside the heat source area in the heater are often too high, which may lead to that the conductive wires produce an excessive amount of heat when the heater is heated. This would affect the thermal test analysis in the heat source area and increase the error of the test. Additionally, the conductive wires outside of the heat source area would have high risk of being burned out due to the high heat. In view of above, the present disclosure provides a solution to the need that overcomes the various problems noted in the art.

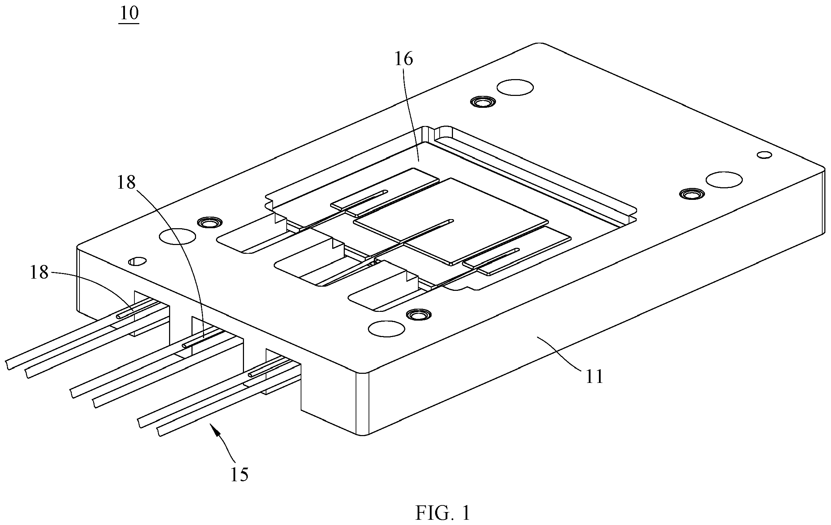

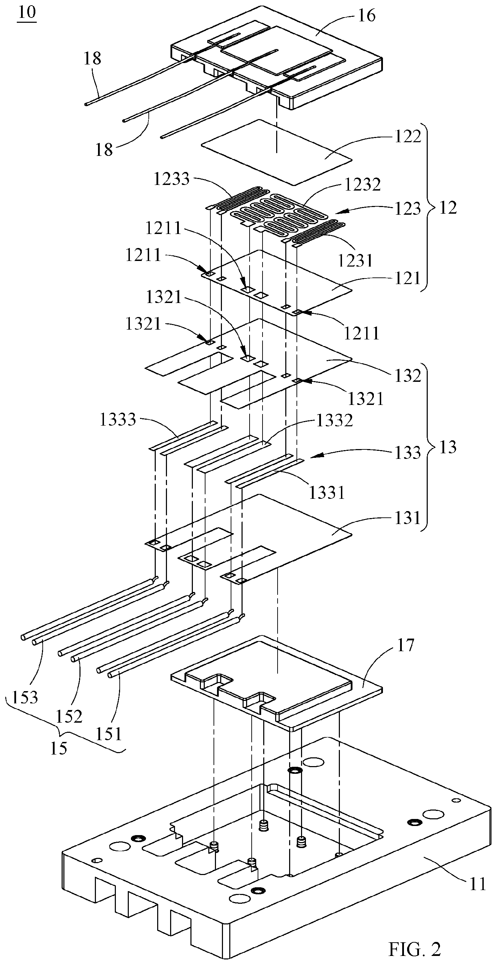

Refer to Fig. 1 and Fig. 2. Fig. 1 illustrates a three-dimensional view of a heating assembly according to a first embodiment of the present disclosure. Fig. 2 illustrates an explosive view of the heating assembly as shown in Fig. 1.

The heating assembly 10 can be used to simulate a heat source. The heating assembly 10 can include a base 11, a heating sheet 12, a wiring sheet 13, multiple conductive members 14, and a connecting cable 15. The heating sheet 12 and the wiring sheet 13 can be disposed on the base 11. The heating sheet 12 can include a first insulating layer 121, a second insulating layer 122, and a heating wire 123. The first insulating layer 121 and the second insulating layer 122 can be made of any suitable insulating material. For example, polyimide or ceramic can be used. The heating wire 123 can be disposed between the first insulating layer 121 and the second insulating layer 122.

The wiring sheet 13 can be a flexible printed circuit board (FPCB). The wiring sheet can include an insulating base layer 131, an insulating cover layer 132, and a wiring cable 133. The wiring cable 133 can be disposed between the insulating base layer 131 and the insulating cover layer 132. The insulating cover layer 132 can be disposed between the insulating base layer 131 and the first insulating layer 121. The impedance of the wiring cable 133 is lower than the impedance of the heating cable 123.

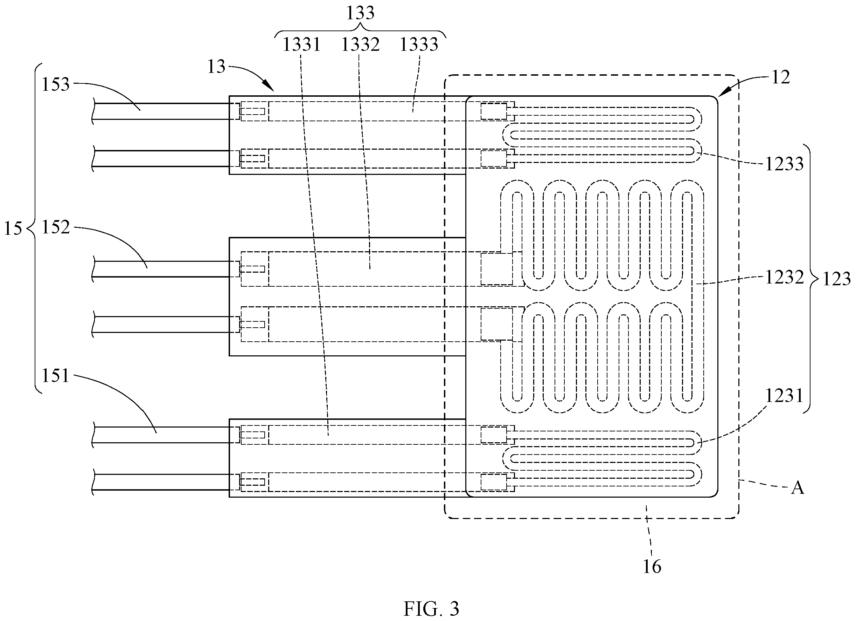

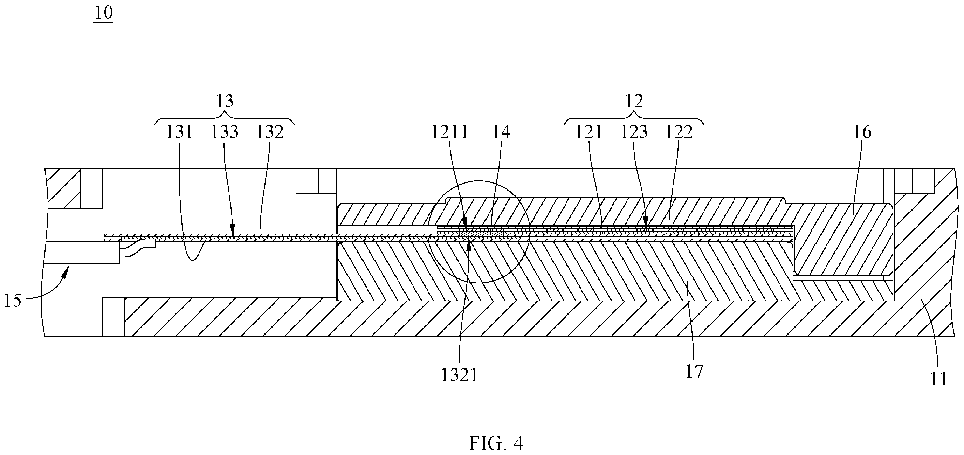

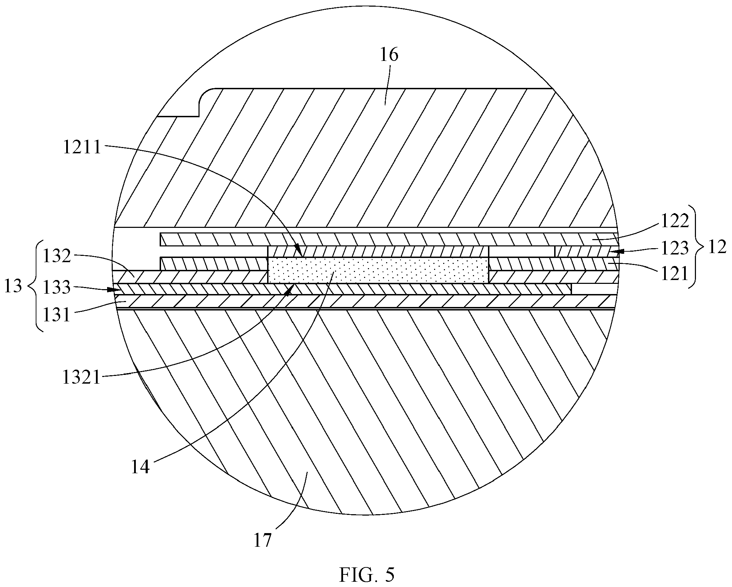

Referring to Fig. 3-5. Fig. 3 illustrates a plane view of the heating sheet 12, wiring sheet 13, and the connecting cable 15 as shown in Fig. 2. Fig. 4 illustrates a sectional view of the heating assembly 10 as shown in Fig. 1. Fig. 5 illustrates an enlarged sectional view of the heating assembly 10 as shown in Fig. 4.

The first insulating layer 121 can include multiple first through holes 1211. The insulating cover layer can include multiple second through holes 1321. The conductive members 14 can be made of any suitable conductive materials. For example, the conductive members 14 can be made of solder. These conductive members 14 can electrically connect the heating wire 123 and the wiring cable 133 via the first through holes 1211 and the second through holes 1321. That is, the heating wire 123 and the wiring cable 133 can be electrically connected to each other via the conductive members 14 through the first through holes 1211 and the second through holes 1321. The connecting cable 15 can be electrically connected to the wiring cable 133 and provide electricity to the heating wire 123.

As shown in Fig. 3, the heating wire 123 can include a first heating sub-wire 1231, a second heating sub-wire 1232, and a third heating sub-wire 1233. These three heating sub-wire 1231, 1232, 1233 can have a wavy shape. At least two of these three heating sub-wires 1231, 1232, 1233 can have different width. At least two of these three heating sub-wires 1231, 1232, 1233 can have different number of peaks. In this way, the first heating sub-wire 1231, the second heating sub-wire 1232, and the third heating sub-wire 1233 can respectively form different heat source according to the different needs of impedance.

The wiring cable 133 can include a first wiring sub-cable 1331, a second wiring sub-cable 1332, and a third wiring sub-cable 1333. The connecting cable 15 can include a first connecting sub-cable 151, a second connecting sub-cable 152, a third connecting sub-cable 153. The first wiring sub-cable 1331 can be electrically connect to the first heating sub-wire 1231 at one end and the first connecting sub-cable 151 at another end. The second wiring sub-cable 1332 can be electrically connect to the second heating sub-wire 1232 at one end and the second connecting sub-cable 152 at another end. The third wiring sub-cable 1333 can be electrically connect to the third heating sub-wire 1233 at one end and the third connecting sub-cable 153 at another end.

Refer back to Fig. 2, the heat assembly 10 can include a first thermal block 16, a second thermal block 17, and multiple heat transfer wires 18. The first thermal block 16 and the second thermal block 17 can be made of any suitable thermal conductive material. For example, the first thermal block 16 and the second thermal block 17 can be made of copper. The first thermal block 16 and the second thermal block 17 can be thermally coupled to the heating sheet 12. The heat transfer wires 18 can connect to the first thermal block 16 and a temperature sensor (not shown). This way, the temperature sensor can provide the current temperature of the heating sheet 12. The connection between the connecting cable 15 and the wiring cable 133 is located outside of the perimeter A of the thermal blocks. Therefore, the connection between the connecting cable 15 and the wiring cable 133 would not interfere with the thermal blocks. The thermal coupling between the thermal blocks 16, 17 and the heating sheet 12 refers to thermal contact or thermal connection through other thermally conductive media. In some embodiments, the heat assembly 10 can include only the first thermal block 16.

Since the wiring cable 133 have a lower impedance than the heating wire 123, when the heating sheet 12 is heated, the wiring cable 133 that is located outside of the heat source would not produce excessive amount of heat to affect the thermal test analysis of the heating wire 123 within the heat source. Therefore, reduce the error of the analysis. In addition, the wiring cable 133 can avoid being burn out due to large amount of heat generated, in turn prolong the service life of the heating assembly.

In the first embodiment, the heating sheet 12 includes a first insulating layer 121, and the wiring sheet 13 includes an insulating cover layer 132. In some embodiments, the first insulating layer and the insulating cover layer can be either one of the two. For example, in some embodiments, the heating assembly can include only the first insulating layer. For example, in some embodiments, the heating assembly can include only the insulating cover layer. In some embodiments, the first insulating layer and the insulating cover layer can be combined into one insulating layer.

In the first embodiment, the heating assembly 10 includes multiple conductive members 14 that electrically connects the heating wire 123 and the wiring cable 133. In some embodiments, the heating assembly 10 can have the heating wire and the wiring cable connect with each other by means of spot welding or laser welding. In the first embodiment, the conductive members 14 are solder. In some embodiments, the conductive member can be any suitable conductive means. For example, the conductive member can be conductive screws, conductive rivets, conductive springs, conductive shrapnel, conductive foams or matching conductive sockets and plugs.

In the first embodiment, the heating assembly include three of each of the heating sub-wire 1231, 1232, 1233, the wiring sub-cable 1331, 1332, 1333, and the connecting sub-cable 151, 152, 153, and are electrically connected through the first through holes 1211 and second through holes 1321. In some embodiments, the heating assembly can include two or less of each of the heating sub-wire, the wiring sub-cable, and the connecting sub-cable. In some embodiments, the heating assembly can include four or more of each of the heating sub-wire, the wiring sub-cable, and the connecting sub-cable. The number of the first through holes and the second through holes can be adjusted to have the same number of the heating sub-wire, the wiring sub-cable, and the connecting sub-cable.

In the first embodiment, two of the first heating sub-wire 1231, the second heating sub-wire 1232, and the third heating sub-wire 1233 can have different width and different number of peaks. In some embodiments, the width and the number of peaks can be the same between the first heating sub-wire, the second heating sub-wire, and the third heating sub-wire.

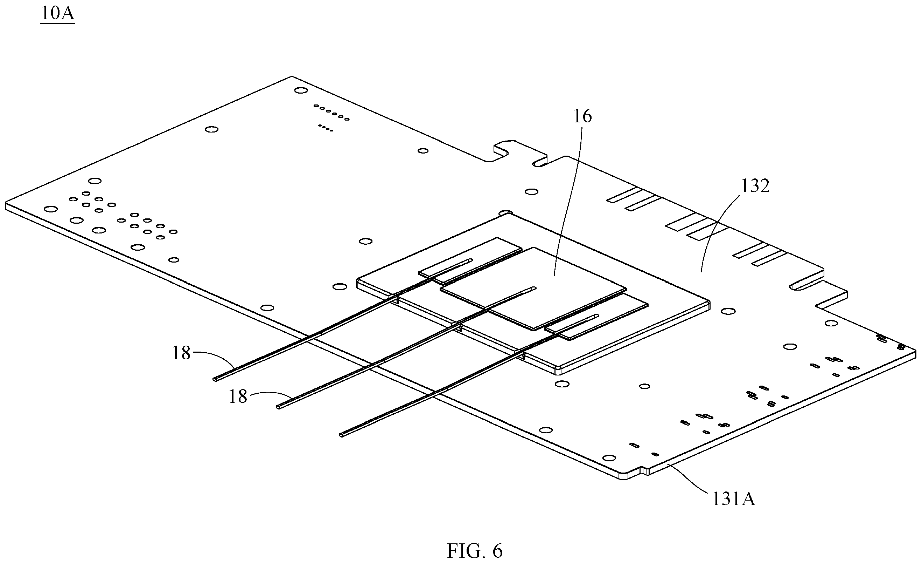

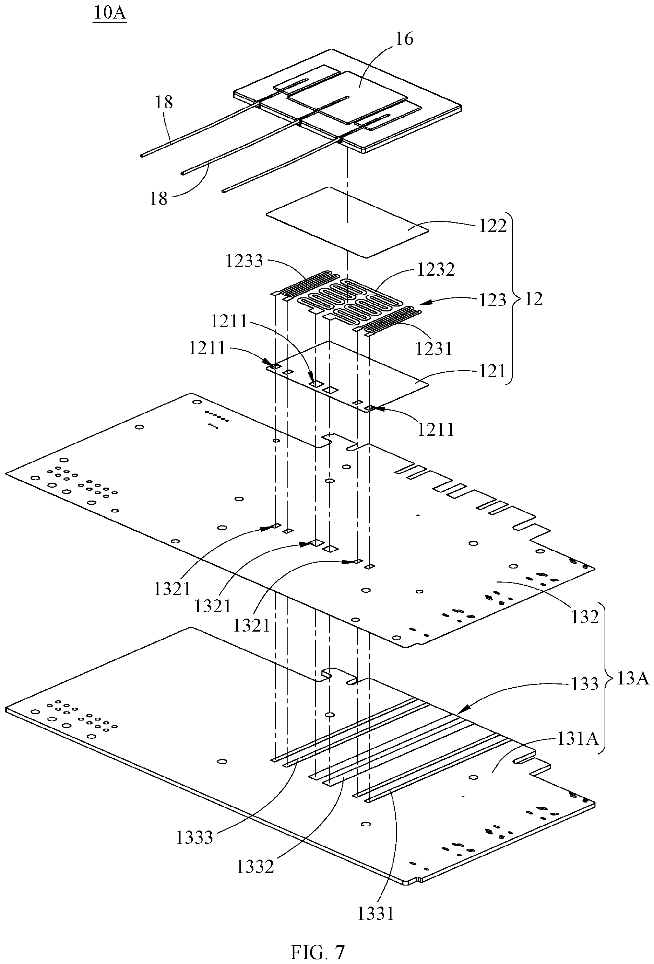

Refer to Fig. 6 and Fig. 7. Fig. 6 illustrates a three-dimensional view of the heating assembly according to a second embodiment of the present disclosure. Fig. 7 illustrates an explosive view of the heating assembly as shown in Fig. 6.

The heating assembly 10A of the second embodiment is similar to the heating assembly 10 of the first embodiment, therefore, only the differences will be explained below. In the heating assembly 10A, the insulating base layer 131A of the wiring sheet 13A is a circuit board. Therefore, the heating assembly 10A can be used with the actual size of a circuit board to perform the thermal test analysis, which in turn can accelerate the development and verification time of the actual products. In addition, multiple other control circuits can be integrated on the circuit board to provide additional functions such as time or current protection.

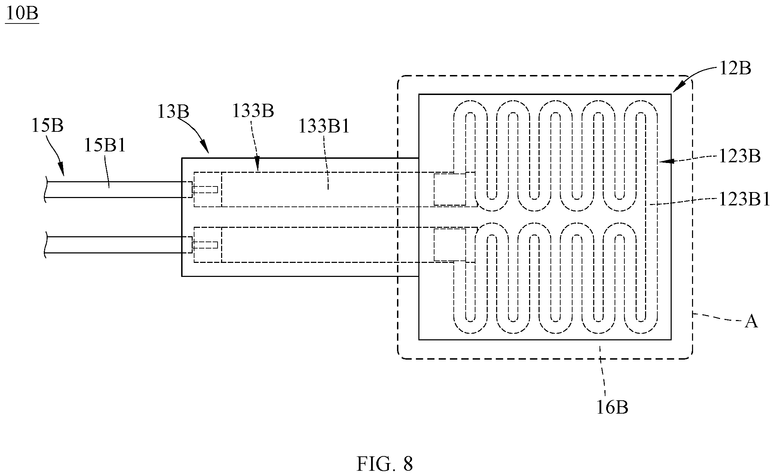

Fig. 8 illustrates a plane view of the heating sheet 12B, wiring sheet 13B, and the connecting cable 15B of a heating assembly 10B according to a third embodiment of the present disclosure. The heating assembly 10B of the third embodiment is similar to the heating assembly 10 of the first embodiment, therefore, only the differences will be explained below. The heating assembly 10B can have one heating wire 123B that includes a single heating sub-wire 123B1. The heating assembly 10B can have one wiring cable 133B that includes a single wiring sub-cable 133B1. The heating assembly 10B can have one connecting cable 15B that includes a single connecting sub-cable 15B1. That is, the heating assembly 10B can have a single heat source.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A heating assembly (10), comprising:
a heating sheet (12) including a first insulating layer (121) and a heating wire (123) disposed on the heating sheet (12); and
a wiring sheet (13) including an insulating base layer (131) disposed on the first insulating layer (121) and a wiring cable (133) disposed on the insulating base layer (131), the wiring cable (133) is electrically connected to the heating wire (123), wherein
the wiring cable (133) has an impedance value that is lower than an impedance value of the heating wire (123).

2. The heating assembly (10) of claim 1, wherein the ratio of the impedance value of the heating wire (123) and the impedance value of the wiring cable (133) is at least 3.

3. The heating assembly (10) of claim 2, wherein the conductive material of the wiring cable (133) is copper or copper alloy having a resistivity of less than 5.00E-05 Ωmm and the conductive material of the heating wire is selected from the group comprising brass having a resistivity of more than 6.00E-05 S2mm, stainless steel having a resistivity of more than 6.00E-04 Ωmm and an FeCrAl alloy having a resistivity of more than 1.00E-03 Ωmm.

4. The heating assembly (10) of one of claims 1 to 3, wherein the heating sheet (12) further includes a second insulating layer (122), the heating wire (123) is disposed between the first insulating layer (121) and the second insulating layer (122).

5. The heating assembly (10) of one of claims 1 to 4, further comprises at least one conductive member, the first insulating layer (121) includes at least one first through hole (1211), the heating wire (123) and the wiring cable (133) are electrically connected to each other via the at least one conductive member through the at least one first through hole (1211).

6. The heating assembly (10) of claim 5, wherein the at least one conductive member is one of a conductive screw, a conductive rivet, a solder, a conductive spring, a conductive spring clip, a conductive foam or a matching conductive socket and plug.

7. The heating assembly (10) of one of claims 1 to 6, wherein the wiring sheet (13) is a flexible printed circuit board.

8. The heating assembly (10) of one of claims 1 to 7, wherein the insulating base layer (131) is a circuit board.

9. The heating assembly (10) of one of claims 1 to 8, wherein the wiring sheet (13) further comprises an insulating cover layer (132), the wiring cable (133) is disposed between the insulating base layer (131) and the insulating cover layer (132), and the insulating base layer (131) is disposed on the first insulating layer (121) through the insulating cover layer (132).

10. The heating assembly (10) of claim 9, further comprises at least one conductive member, the first insulating layer (121) includes at least one first through hole (1211), the insulating cover layer (132) includes at least one second through hole (1321), the heating wire (123) and the wiring cable (133) are electrically connected to each other via the at least one conductive member through the at least one first through hole (1211) and the at least one second through hole (1321).

11. The heating assembly (10) of one of claims 1 to 10, wherein the heating wire (123) comprises a first heating sub-wire (1231), a second heating sub-wire (1232), and a third heating sub-wire (1233) that are separated from each other, at least two of the first heating sub-wire (1231), the second heating sub-wire (1232), and the third heating sub-wire (1233) have a different width, and
the wiring cable (133) comprises a first wiring sub-wire (1331), a second wiring sub-wire (1332), and a third wiring sub-wire (1333) that are separated from each other and electrically connected to the first heating sub-wire (1231), the second heating sub-wire (1232), and the third heating sub-wire (1233) respectively.

12. The heating assembly (10) of claim 11, wherein the first heating sub-wire (1231), the second heating sub-wire (1232), and the third heating sub-wire (1233) are wave-shaped, and at least two of the first heating sub-wire (1231), the second heating sub-wire (1232), and the third heating sub-wire (1233) have a different number of peaks.

13. The heating assembly (10) of one of claims 1 to 12 further comprises a connecting cable (15) that is connected to the wiring cable (133).

14. The heating assembly (10) of claim 13 further comprises a thermal block thermally coupled to the heating sheet (12) and a connection point between the connecting cable (15) and the wiring cable (133) is located outside of a perimeter of the thermal block.
